# EUROPEAN PATENT APPLICATION

(11) **EP 2 966 535 A1**
(43) Date of publication of application: **13.01.2016**
(21) Application number: 15176071.7
(22) Date of filing: 09.07.2015
(51) Int. Cl.: G05F 1/565, G05F 3/18, H02M 1/00

(54) **DEPLETION MODE MOSFET POWER SUPPLY**

(30) Priority: 09.07.2014 US 201462022544 P
(71) Applicant: Numerex Corp., Atlanta, GA 30339 (US); Montrose, Rodney Clay, Allen, TX 75013 (US); Keller, John, Plano, TX 75094 (US); Smith, Jeffrey O., Dallas, TX 75229 (US)
(72) Inventor: MONTROSE, Rodney Clay, Allen, TX 75013 (US); KELLER, John, Plano, TX 75094 (US); SMITH, Jeffrey O., Dallas, TX 75229 (US)
(74) Representative: Gosnall, Toby

(57) **Abstract**

A low current power supply circuit is described that includes a depletion mode metal-oxide-semiconductor field-effect transistor (MOSFET) having a gate, a source and a drain. The drain is connectable to a power source and the source provides an output voltage for the power supply. A zener diode is connected to the gate of the depletion mode MOSFET configured to operating in its break down mode. A resistor is connected between the source and the gate of the depletion mode MOSFET and is operable to limit current to the zener diode such that the zener diode is kept in a breakdown state during operation. An output capacitor connected between the output voltage and ground.

## Description

### CROSS REFERENCE TO RELATED INFORMATION

This application claims the benefit of U.S. Provisional Patent Application No. 62/022,544, filed July 9, 2014, titled Depletion Mode MOSFET Power Supply, the contents of which are hereby incorporated herein in its entirety.

### TECHNICAL FIELD

The present disclosure is directed to direct current (DC) power supplies, and more particularly to low-current power supplies employing a MOSFET in depletion mode.

### BACKGROUND OF THE INVENTION

Energy efficiency has become a great concern for many reasons. Mobile devices are becoming more common and smaller, making battery life a major issue. Climate change is driving interest in more efficient electronics. For these reasons there are many applications for power supplies that provide low current outputs and that can run from many different inputs, such as various battery voltages and types and alternating current (AC) power sources.

Mobile devices in particular provide applications for power supplies that are operable under various and variable input power and that provide stable output voltages and low current outputs. Mobile devices can range from remote and wireless sensors, wireless communications, vehicle monitoring and tracking systems and other mobile applications. Each of these applications uses batteries or AC power sources that come in a variety of forms. Remote sensors may use small 3.3, 5, 9 or 12 volt batteries. Vehicle mounted electronics may run from the vehicles electrical system which can be 12V in cars, 24V in trucks or 76V in trains. Even these voltages are not stable and vary as a function of battery charge. In other applications, low current power supplies can be used to provide start-up current to power supply controllers and other electronics.

What is needed is a low current power supply that can operate under a variety of input voltages.

### BRIEF SUMMARY OF THE INVENTION

In a preferred embodiment, a power supply circuit is described that uses a depletion mode metal-oxide-semiconductor field-effect transistor (MOSFET) having a gate, a source and a drain, where the drain is connectable to a power source and the source provides an output voltage for the power supply. A zener diode has its cathode connected to the gate of the depletion mode MOSFET and anode connected to a ground. A resistor is connected between the source and the gate of the depletion mode MOSFET to limit current to the zener diode such that the zener diode is kept in a breakdown state during operation, and an output capacitor connected between the output voltage and ground.

The foregoing has outlined rather broadly the features and technical advantages of the present invention in order that the detailed description of the invention that follows may be better understood. Additional features and advantages of the invention will be described hereinafter which form the subject of the claims of the invention. It should be appreciated by those skilled in the art that the conception and specific embodiment disclosed may be readily utilized as a basis for modifying or designing other structures for carrying out the same purposes of the present invention. It should also be realized by those skilled in the art that such equivalent constructions do not depart from the spirit and scope of the invention as set forth in the appended claims. The novel features which are believed to be characteristic of the invention, both as to its organization and method of operation, together with further objects and advantages will be better understood from the following description when considered in connection with the accompanying figures. It is to be expressly understood, however, that each of the figures is provided for the purpose of illustration and description only and is not intended as a definition of the limits of the present invention.

### BRIEF DESCRIPTION OF THE DRAWINGS

For a more complete understanding of the present invention, reference is now made to the following descriptions taken in conjunction with the accompanying drawings, in which:

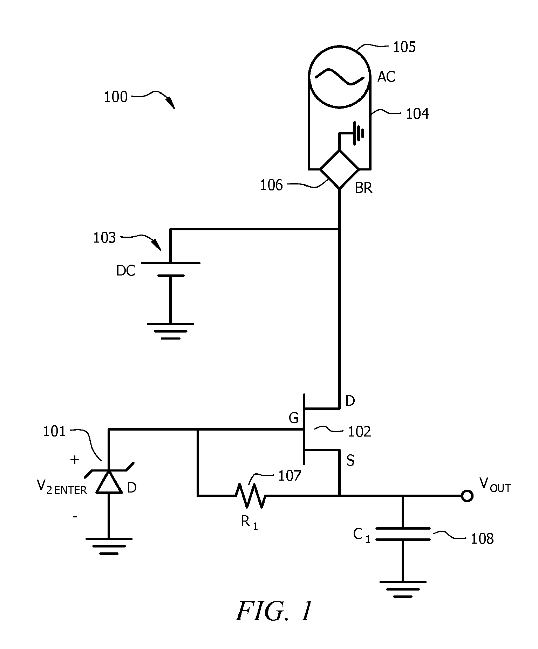

FIG. 1 is a circuit diagram of a preferred embodiment of a power supply circuit according to the concepts described herein.

### DETAILED DESCRIPTION OF THE INVENTION

Referring now to Figure 1, an embodiment of a depletion mode metal-oxide-semiconductor field-effect transistor (MOSFET) power supply 100 is shown. In a preferred embodiment of a power supply according to the concepts described herein, a depletion mode MOSFET power supply 100 is formed by a zener diode 101 is connected to the gate of a MOSFET 102. The cathode of the zener diode 101 is connected to the gate of MOSFET 102, while the anode is connected to ground. The zener diode 101 is preferrably a tradition zener diode that allows current to flow in the forward direction in the same manner as an ideal diode, but also permits it to flow in the reverse direction when the voltage is above a certain value known as the breakdown voltage, also referred to as the zener knee voltage, zener voltage, avalanche point, or peak inverse voltage. Since the breakdown voltage of the zener diode is stable, the power supply 100 uses the breakdown voltage of zener diode 101 to provide a voltage input to the gate of MOSFET 102.

A DC power supply 103 and/or an AC power supply 104, formed by an AC source 105 coupled to a rectifier 106 is connected to the drain of the MOSFET 102. While both types of power supplies are pictured, in some embodiments only one of the two may be present in the circuit. The output of the DC power supply or the rectifier may be any of many DC voltages, for example from 3 V up to 180 V. Certain types of batteries may provide output voltages of 3V, 5V, 6V, 9V or other voltages, a car battery and/or alternator may provide 12 V, a truck battery and/or alternator may provide 24V, and a train battery and/or alternator may provide 76V. The output of the DC power supply and/or the rectifier is be to the drain of a MOSFET 102, while the MOSFET 102 is preferably a depletion mode MOSFET. In a depletion-mode MOSFET, the device is normally ON at zero gate-source voltage. Such devices are used as load "resistors" in logic circuits (in depletion-load NMOS logic, for example). For N-type depletion-load devices, the threshold voltage might be about -3 V, so it could be turned off by pulling the gate 3 V negative (the drain, by comparison, is more positive than the source in NMOS). In PMOS, the polarities are reversed.

The source of the MOSFET 102 is connected in a feedback loop to the gate of the MOSFET with the resistor R1 107 in series. The source of the MOSFET may also be coupled to a capacitor C1 108. The capacitor value may be selected to handle any fluctuations in load voltage/current draw at Vout. The output voltage of the circuit may be regulated to a low current low-voltage application, for example 3.3 V. The output voltage is determined based upon the breakdown voltage of the zener diode. R1 may be selected in order to limit current to the zener diode such that the zener diode is kept in a breakdown state.

The output voltage Vout of the power supply when the diode is operating in breakdown mode, is equal to the breakdown voltage of the zener diode 101 plus the drain to source drop of the MOSFET 102.

Although the present invention and its advantages have been described in detail, it should be understood that various changes, substitutions and alterations can be made herein without departing from the spirit and scope of the invention as defined by the appended claims. Moreover, the scope of the present application is not intended to be limited to the particular embodiments of the process, machine, manufacture, composition of matter, means, methods and steps described in the specification. As one of ordinary skill in the art will readily appreciate from the disclosure of the present invention, processes, machines, manufacture, compositions of matter, means, methods, or steps, presently existing or later to be developed that perform substantially the same function or achieve substantially the same result as the corresponding embodiments described herein may be utilized according to the present invention. Accordingly, the appended claims are intended to include within their scope such processes, machines, manufacture, compositions of matter, means, methods, or steps.

## Claims

1. A power supply circuit comprising:
a field effect transistor (FET) having a gate, a source and a drain, wherein the drain is connectable to a power source and the source provides an output voltage for the power supply;
a zener diode having an anode and a cathode, the cathode of the zener diode connected to the gate of the FET; and
a resistor connected between the source and the gate of the FET, the resistor operable to limit current to the zener diode such that the zener diode is kept in a breakdown state during operation.

2. The power supply of claim 1 further comprising a capacitor connected between the source of the FET and ground, the capacitor operable to handle any fluctuations in load voltage and current draw at the output voltage.

3. The power supply of claim 1 or claim 2 wherein the FET is a metal-oxide-semiconductor field-effect transistor (MOSFET).

4. The power supply of claim 3 wherein the MOSFET is a depletion mode MOSFET.

5. The power supply of any preceding claim wherein the power supply is a direct current power supply, optionally a battery, further optionally a vehicle battery.

6. The power supply of any preceding claim wherein the power supply is an alternating current power supply.

7. The power supply of any preceding claim wherein the power supply is a combination of a direct current power supply and an alternating current power supply.

8. The power supply of any preceding claim wherein the output voltage is 3.3 volts.

9. A power supply circuit comprising:
a depletion mode metal-oxide-semiconductor field-effect transistor (MOSFET) having a gate, a source and a drain, wherein the drain is connectable to a power source and the source provides an output voltage for the power supply;
a zener diode having an anode and a cathode, the cathode of the zener diode connected to the gate of the depletion mode MOSFET and the anode connected to a ground;
a resistor connected between the source and the gate of the depletion mode MOSFET, the resistor operable to limit current to the zener diode such that the zener diode is kept in a breakdown state during operation; and
an output capacitor connected between the output voltage and ground.

10. The power supply of claim 9 wherein the output capacitor is operable to handle any fluctuations in load voltage and current draw at the output voltage.

11. The power supply of claim 9 or claim 10 wherein the power supply is a direct current power supply, optionally a battery, further optionally a vehicle battery.

12. The power supply of any of claims 9 to 11 wherein the power supply is an alternating current power supply.

13. The power supply of any of claims 9 to 12 wherein the power supply is a combination of a direct current power supply and an alternating current power supply.

14. The power supply of any of claims 9 to 13 wherein the output voltage is 3.3 volts.

15. The power supply of any of claims 9 to 14 wherein the power supply is used to supply low voltage DC to operate a switching DC-DC converter incorporating an output FET switch that can operate from the high input voltage.
